# EUROPÄISCHE PATENTSCHRIFT

(11) **EP 0 565 653 B1**
(45) Veröffentlichungstag und Bekanntmachung des Hinweises auf die Patenterteilung: **12.04.1995**
(21) Anmeldenummer: 92918642.7
(22) Anmeldetag: 04.09.1992
(51) Int. Cl.: H05K 7/10, H01R 23/68

(54) **ELEKTRISCHES GERÄT, INSBESONDERE SCHALT- UND STEUERGERÄT FÜR KRAFTFAHRZEUGE**
ELECTRICAL DEVICE, ESPECIALLY A CONNECTING AND CONTROL DEVICE FOR MOTOR VEHICLES
APPAREIL ELECTRIQUE, EN PARTICULIER APPAREIL DE CONNEXION ET DE COMMANDE POUR VEHICULES AUTOMOBILES

(30) Priorität: 05.11.1991 DE 4136381
(43) Veröffentlichungstag der Anmeldung: 20.10.1993
(73) Patentinhaber: ROBERT BOSCH GMBH, 70442 Stuttgart (DE)
(72) Erfinder: HOFMEISTER, Werner, D-7130 Mühlacker (DE); ERNST, Waldemar, D-7143 Vaihingen-Enz (DE)
(86) Internationale Anmeldenummer: DE9200743
(87) Internationale Veröffentlichungsnummer: WO9309656

(56) Entgegenhaltungen:
- DE-A- 3 401 428
- US-A- 3 264 597
- US-A- 4 881 901
- US-A- 5 102 342
- IBM Technical Disclosure Bulletin, Band. 8, Nr. 10, März 1966;D.L. Wilcox et al:"PACKAGING FOR MONOLITHIC CIRCUITS ",

## Beschreibung

### Stand der Technik

Die Erfindung geht aus von einem elektrischen Gerät nach der Gattung des Patentanspruchs 1.

Bei derartigen bekannten Geräten sind sich im Betrieb erwärmende Leistungsbauelemente zusammen mit anderen Bauelementen der elektrischen Schaltung direkt auf der Leiterplatte oder auf Kühlelementen aufgebracht, die auf oder an der Leiterplatte befestigt sind.

Mit größer werdendem Funktionsumfang solch elektrischer Geräte wird die thermische Belastung der Bauelemente der elektrischen Schaltung durch vermehrten Stromfluß erhöht.

Desweiteren führt der größer werdende Funktionsumfang zu einer Zunahme der Packungsdichte der Bauelemente auf der Leiterplatte, wodurch sich die Temperaturbelastung der Bauelemente zusätzlich erhöht.

Da mit steigender Betriebstemperatur die Lebensdauer der elektrischen Bauelemente abfällt, ist aus Gründen der Funktionssicherheit der elektrischen Schaltung eine neue Art der Anordnung der Bauelemente der Schaltung, insbesondere der die meiste Verlustleistung erzeugenden Bauelemente, in dem elektrischen Gerät erforderlich.

### Vorteile der Erfindung

Das erfindungsgemäße elektrische Gerät mit den kennzeichnenden Merkmalen des Patentanspruchs 1 hat demgegenüber den Vorteil, daß durch die räumliche Trennung der Leistungsbauelemente von dem Signalverarbeitungselementen, die weiterhin auf einer Leiterplatte angeordnet sind, eine thermische Entkopplung dieser beiden funktionsverschiedenen Bauelementgruppen erzielt wird.

Durch die Anbringung der Leistungsbauelemente an das eine hohe Wärmekapazität und geringen Wärmewiderstand aufweisende Gehäuse wird die große Verlustleistung rasch abgeleitet, ohne daß die übrigen Bauelemente im Gehäuse schädigend erwärmt werden.

Ein weitere Vorteil ist, daß durch die getrennte Anordnung der Signalverarbeitungselemente von den Leistungsbauelementen, wobei letztere durch hohe Spannungen und Ströme gekennzeichnet sind, die elektromagnetische Verträglichkeit (EMV) zwischen diesen beiden Elementearten verbessert wird.

Die Teilung der Steckerleiste trägt der getrennten Anordung der Bauelemente Rechnung, so daß die Leiterplatten mit den Signalverarbeitungselementen mit den zweiten Steckerverbindungsteilen des Einsetzteils vormontierbar ist.

Durch die in den Unteransprüchen aufgeführten Maßnahmen sind vorteilhafte Weiterbildungen und Verbesserungen des im Anspruch 1 angegebenen elektrischen Geräts möglich. Mit der Verwendung eines Substrats als Wärmeleitfolie nach Anspruch 2 wird ein guter Wärmeübergang zwischen Leistungsbauelement und dem Gehäuse sichergestellt und durch die im Substrat angeordneten Anschlußbahnen oder Durchkontaktierungen eine Kontaktierung des Leistungsbauelements ermöglicht.

### Zeichnung

In der Zeichnung ist ein Ausführungsbeispiel der Erfindung dargestellt, das nachfolgend näher beschrieben wird.

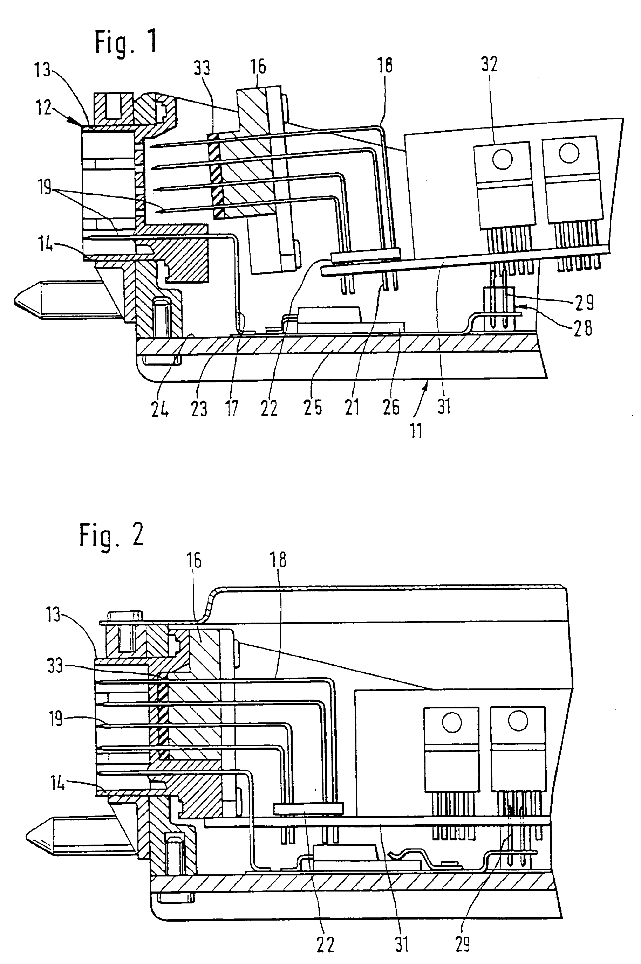

Es zeigen, jeweils im Längsschnitt und ausschnittsweise, Figur 1 das elektrische Gerät in vormontiertem und Figur 2 das elekrische Gerät in montiertem Zustand.

### Beschreibung des Ausführungsbeispiels

In Figur 1 ist in einem Gehäuse 11 eines elektrischen Gerätes, insbesondere eines Schalt- und Steuergerätes eines Kraftfahrzeuges, eine Steckerleiste 12 gelagert, die an ihrer Vorderseite einen Aufnahmekörper 13 zur Aufnahme eines nicht dargestellten Gegensteckers aufweist.

Die Steckerleiste 12 ist geteilt und setzt sich zusammen aus einem stationären, im Gehäuse 11 fixierten Grundkörper 14 und ein in den Grundkörper 14 einfügbares Einsetzteil 16.

In dem Grundkörper 14 sind mehrere erste Steckverbindungsteile 17 und in das Einsetzteil 16 mehrere zweite Steckverbindungsteile 18 eingesetzt. Die Steckverbindungsteile 17, 18 sind als Flachstecker ausgeführt und weisen an einem Ende Steckabschnitte 19 auf, die in dem Aufnahmekörper 13 positionierbar sind, wie dies in der Figur 1 mit den Steckabschnitten 19 des Grundkörpers 14 dargestellt ist.

Die anderen Enden der Steckverbindungsteile 17, 18 sind als Anschlußfahnen 21 ausgebildet. Die Anschlußfahnen 21 der Steckverbindungsteile 17 sind mit zugeordneten, nicht gezeigten Anschlußbahnen eines Substrats 23, das als Wärmeleitfolie ausgebildet ist, elektrisch leitend verbunden.

Das Substrat 23 ist an einer Innenseite 24 einer Außenwand 25 des Gehäuses 11 angebracht und teilweise von einem Leistungsbauelement 26 überdeckt, das auf das Substrat 23 geklebt ist. Alternativ kann das Leistungsbauelement 26 auch auf das Substrat 23 geklammert werden oder mit diesem in SMD-Technik (Surface mounted devices - oberflächenmontierte Bauelemente) verbunden sein.

Die Anschlußbahnen sind desweiteren kontaktiert mit nicht dargestellten Anschlüssen des Leistungsbauelements 26 bzw. Anschlüssen eines Leiterplattenkontaktsteckers 28.

Der Leiterplattenkontaktstecker 28 ist mittels Steckstiften 29 an nur symbolisch und unmaßstäblich dargestellten Leiterbahnen 22 einer Leiterplatte 31 anschließbar. Die Leiterplatte 31 ist mit Signalverarbeitungselementen 32 bestückt. Die Signalverarbeitungselemente 32 und das Leistungsbauelement 26 bilden zusammen die elektrische Schaltung des Schalt und Steuergeräts.

Alternativ kann die Schaltung auch mehrere Leistungsbauelemente 26 enthalten.

Einige der Leiterbahnen 22 der Leiterplatte 31 sind desweiteren mit den Anschlußfahnen 21 der zweiten Steckverbindungsteile 18 kontaktiert, die in dem Einsetzteil 16 gelagert sind. Dieses trägt stirnseitig ein Dichtmittel 33.

Figur 2 zeigt das im Grundkörper 14 eingefügte Einsetzteil 16. Mit dem Einfügen wird das Dichtmittel 33 durch Anlage an dem Grundkörper 14 federelastisch verformt und dadurch die zweiten Steckverbindungsteile 18 gegen von dem Aufnahmekörper 13 vordringende Feuchtigkeit abgedichtet.

Mit der Einfügung des Einsetzteiles 16 in den Grundkörper 14, die beispielsweise über Schnappelemente oder Schrauben gesichert ist, gelangen einerseits alle Steckabschnitte 19 in den Aufnahmekörper 13 und andererseits die Steckstifte 29 in ihre Kontaktstellung mit zugeordneten Leiterbahnen 22 der Leiterplatte 31. Alternativ können auch mehrere Leiterplatten 31 in dem Schalt- und Steuergerät angeordnet sein.

Durch die zuvor beschriebene Anordnung ist trotz räumlicher Trennung und mit thermischer Entkopplung der Signalverarbeitungselemente 32 von dem Leistungsbauelement 26 die interne Verbindungen des Schalt- und Steuergerätes in vormontierbarer und damit fertigungstechnisch günstiger Weise vollzogen.

Mit der Ausgliederung des Leistungsbauelement 26 von der Leiterplatte 31 entfallen insbesondere auch sonst erforderliche, dem hohen Stromfluß des Leistungsbauelements 26 angepaßte breite Leiterbahnen 22 auf der Leiterplatte 31, so daß dieser zuvor auf der Leiterplatte 31 benötigte Platz zu einer Verringerung der Packungsdichte der verbleibenden Signalverarbeitungselmente 32 und zu einer thermischen Entlastung derselben führt.

## Patentansprüche

1. Elektrisches Gerät, insbesondere Schalt- und Steuergerät für Kraftfahrzeuge, mit einem Gehäuse (11), an dem eine Steckerleiste (12) angebracht ist, deren Steckverbindungsteile (17, 18) in Verbindung stehen mit einer, im Gehäuse (11) angeordneten, aus Signalverarbeitungselementen (32) und mindestens einem Leistungsbauelement (26) bestehenden elektrischen Schaltung, dadurch gekennzeichnet, daß die Steckerleiste (12) geteilt ist in einen Grundkörper (14) mit mehreren ersten Steckverbindungsteilen (17) und ein, mehrere zweite Steckverbindungsteile (18) enthaltenes Einsetzteil (16), das in den Grundkörper (14) einfügbar ist: die ersten Steckverbindungsteile (17) verbunden sind mit dem an einer Innenseite (24) des Gehäuses (11) unter Zwischenlage eines Substrats (23) angebrachten Leistungsbauelement (26); die zweiten Steckverbindungsteile (18) verbunden sind mit Leiterbahnen (22) mindestens einer, die Signalverarbeitungselemente (32) tragenden Leiterplatte (31); und das Leistungsbauelement (26) über einen Leiterplattenkontaktstecker (28) mit Signalverarbeitungselementen (32) verbunden ist.

2. Elektrisches Gerät nach Anspruch 1, dadurch gekennzeichnet, daß die Verbindung der ersten Steckverbindungsteile (17) mit dem an der Innenseite (24) des Gehäuses (11) angebrachten Leistungsbauelement (26) unter Zwischenlage eines Substrats (23) erfolgt und daß das Substrat (23) eine, elektrische Anschlußbahnen führende Wärmeleitfolie ist.

3. Elektrisches Gerät nach Anspruch 2, dadurch gekennzeichnet, daß die Anschlußbahnen die elektrische Verbindung vom Leistungsbauelement (26) einerseits zu den ersten Steckverbindungsteilen (17) und andererseits zu den Leiterplattenkontaktstecker (28) herstellen.

4. Elektrisches Gerät nach Anspruch 1 bis 3, dadurch gekennzeichnet, daß das Leistungsbauelement (26) auf dem Substrat (23) durch Kleben, Klammern oder in SMD-Technik festgelegt ist.

5. Elektrisches Gerät nach einem der vorstehenden Ansprüche, dadurch gekennzeichnet, daß das Einsetzteil (16) mit einem Dichtmittel (33) gegenüber dem Grundkörper (14) abgedichtet ist.

## Claims

1. Electrical device, especially switching and control device for motor vehicles, having a housing (11) on which a male connector strip (12) is fixed, the plug connection parts (17, 18) of which are connected to an electrical circuit arranged in the housing (11) and consisting of signal processing elements (32) and at least one power component (26), characterized in that the male connector strip (12) is divided into a base body (14) having a plurality of first plug connection parts (17) and an insertion part (16) which contains a plurality of second plug connection parts (18) and can be inserted into the base body (14); the first plug connection parts (17) are connected to the power component (26) fixed on an inner side (24) of the housing (11) with the interposition of a substrate (23); the second plug connection parts (18) are connected to conductor tracks (22) of at least one printed circuit board (31) which carries the signal processing elements (32); and the power component (26) is connected to signal processing elements (32) via a printed-circuit-board contact plug (28).

2. Electrical device according to Claim 1, characterized in that the first plug connection parts (17) are connected to the power component (26) fixed on the inner side (24) of the housing (11) with the interposition of a substrate (23), and in that the substrate (23) is a thermally conducting foil guiding electrical connection tracks.

3. Electrical device according to Claim 2, characterized in that the connection tracks provide electrical connection of the power component (26), on the one hand to the first plug connection parts (17) and, on the other hand, to the printed-circuit-board contact plug (28).

4. Electrical device according to Claims 1 to 3, characterized in that the power component (26) is fastened on the substrate (23) by bonding, (clipping or using SMD technology.

5. Electrical device according to one of the preceding claims, characterized in that the insertion part (16) is sealed with respect to the base body (14) using a sealing means (33).

## Revendications

1. Appareil électrique notamment appareil de connexion et de commande de véhicules automobiles comportant un boîtier (11) muni d'une barrette de fiche (12) dont les pièces de liaison de fiche (17, 18) sont reliées à un circuit électrique monté dans le boîtier (11) et comprenant des éléments de traitement de signal (32) et au moins un composant de puissance (26), caractérisé en ce que la barrette de prise (12) est divisée en un corps de base (14) avec plusieurs premières parties de liaison de connexion (17) et plusieurs secondes parties de liaison de connexion (18) contenues dans une pièce enfichable (16) qui s'introduit dans le corps de base (14) ; les premières pièces de liaison d'enfichage (17) sont reliées à l'élément de puissance (26) prévu sur une face intérieure (24) du boîtier (11) avec interposition d'un support (23), les secondes parties de fiche de liaison (18) sont reliées aux chemins conducteurs (22) d'au moins une plaque de circuit imprimé (31) qui porte les éléments de traitement de signal (32) et le composant de puissance (26) est relié aux éléments de traitement de signal (32) par une fiche de contact de circuit imprimé (28).

2. Appareil électrique selon la revendication 1, caractérisé en ce que la liaison des premières parties de fiche de connexion (17) à l'élément de puissance (26) monté sur le côté intérieur (24) du boîtier (11) est faite avec interposition d'un support (23) qui est une feuille de conduction thermique avec des chemins de branchement électriques.

3. Appareil électrique selon la revendication 2, caractérisé en ce que les chemins de branchement assurent la liaison électrique, d'une part entre le composant de puissance (26) et les premières parties de liaison enfichables (17) et, d'autre part avec la fiche de contact de la plaque de circuit imprimé (28).

4. Appareil électrique selon les revendications 1 à 3, caractérisé en ce que le composant de puissance (26) est fixé sur le substrat (23) par collage, agrafage ou en technique SMD.

5. Appareil électrique selon l'une des revendications précédentes, caractérisé en ce que la partie insérable (16) est rendue étanche par rapport au corps de base (14) par un joint d'étanchéité (33).
